# EUROPÄISCHE PATENTANMELDUNG

(11) **EP 4 664 508 A1**
(43) Veröffentlichungstag der Anmeldung: **17.12.2025**
(21) Anmeldenummer: 24181816.0
(22) Anmeldetag: 12.06.2024
(51) Int. Cl.: H01L 21/28, H10D 62/832, H10D 64/62

(54) **BEI RAUMTEMPERATUR STROMLEITENDE NANODRÄHTE AUS SILIZIUMCARBID**

(71) Anmelder: Friedrich-Alexander-Universität Erlangen-Nürnberg, in Vertretung des Freistaates Bayern, 91058 Erlangen (DE)
(72) Erfinder: Krsti , Vojislav, 91054 Erlangen (DE); Gray, Maria Magdalena, 91058 Erlangen (DE)
(74) Vertreter: Lorenz Seidler Gossel Part. mbB

(57) **Zusammenfassung**

Die vorliegende Erfindung betrifft ein mikroelektronisches Bauteil mit einem zumindest teilweise aus vorzugsweise dotiertem Silizium-Carbid bestehenden Substrat, einer Anzahl an auf dem Substrat angeordneten, zumindest teilweise aus Silizium-Carbid bestehenden Nanodrähten, wobei eine dem Substrat abgewandte Oberfläche eines oder mehrerer der Nanodrähte zumindest teilweise mit einer Nickel-Legierung versehen ist. Hierbei hat sich überraschend gezeigt, dass die Nanodrähte im Niederspannungsbereich, eine lineare, ohmsche Widerstandscharakteristik aufweisen.

## Beschreibung

Die vorliegende Erfindung betrifft ein mikroelektronisches, vorzugsweise ein quantenelektronisches, Bauteil mit einem Substrat und einer Anzahl an auf dem Substrat angeordneten, zumindest teilweise aus Silizium-Carbid, vorzugsweise 4H-SiC, bestehenden Nanodrähten. Die Nanodrähte sind top-down definierte 4H-SiC-Drähte vorzugsweise nanoskalige und mit Quantentransporteigenschaften bei Raumtemperatur und in Luft.

Momentan besteht ein Streben nach hochwertigen Materialgrundlagen für mikroskopische und quantenelektronische Komponenten für innovative Anwendungen.

Obwohl Ansätze, bei denen CMOS-kompatibles Silizium oder zweidimensionale Schichtmaterialien zum Einsatz kommen, bereits in Ansätzen bekannt sind, wird weiterhin nach alternativen Materialgrundlagen gesucht, die einen Paradigmenwechsel und neue Möglichkeiten für (Quanten-)Bauelementstrukturen und Bauelementintegration ermöglichen.

Eine Anforderung an eine derartige Materialgrundlage sind hervorragende Ladungstransporteigenschaften bzw. die Fähigkeit zum Leiten von Strom vorzugsweise im Zusammenspiel mit einer Quantisierung und jenseits kryogener Bedingungen.

Der vorliegenden Erfindung liegt vor diesem Hintergrund die Aufgabe zugrunde, die Nachteile des Stands der Technik zu beseitigen und insbesondere eine derartige Materialgrundlage zu schaffen.

Erfindungsgemäß kommt hierbei Silizium-Carbid, vorzugsweise 4H-SiC, zum Einsatz. 4H-SiC hat aufgrund seiner hohen Produktionsqualität und seiner ausgereiften Dotierungstechnologie enormen Nutzen in der Leistungselektronik gezeigt, wurde aber für Anwendungen im Nanometerbereich herkömmlich nicht verwendet. Vielmehr lag der Fokus gemäß des Stands der Technik auf der Verwendung von Silizium-Carbid im Mikrometerbereich.

Der vorliegenden Erfindung lag die Erkenntnis zugrunde, dass von oben nach unten (top-down) definierte niedrigdimensionale 4H-SiC-Nanodrähte bei Raumtemperatur überraschend hohe elektrische Leitfähigkeiten und vorzugsweise lange Phasenkohärenzzeiten bieten können. Gemäß der herrschenden Meinung auf dem einschlägigen technischen Gebiet wurde auf Grund der erwarteten Oberflächenunregelmäßigkeiten lange Zeit die Realisierung solcher elektrisch leitender Nanodrähte für nicht als technisch umsetzbar angesehen.

Dieses Leitfähigkeitsregime ist vermutlich auf eine signifikante Subband-Quantisierung zurückzuführen, wie numerische Simulationen zeigen, die in der Halbleiternatur von 4H-SiC mit großer Bandlücke begründet ist.

Die erfindungsgemäßen Nanodrähte qualifizieren sich somit als elektrisch operationelle nanoskopische Drähte mit vorzugsweise quantisierungsbezogenen Eigenschaften bei Raumtemperatur und die erfindungsgemäßen mikroelektronischen Bauteile stellen erste Bauelemente einer elektrisch angetriebenen Quantenmaterial-Plattform bei Raumtemperatur dar.

Ein erster Aspekt der Erfindung betrifft ein mikroelektronisches Bauteil, mit:
einem zumindest teilweise aus vorzugsweise dotiertem Silizium-Carbid, vorzugsweise 4H-SiC, bestehenden Substrat,
einer Anzahl an auf dem Substrat angeordneten, zumindest teilweise aus Silizium-Carbid, vorzugsweise 4H-SiC, bestehenden Nanodrähten, wobei
eine dem Substrat abgewandte Oberfläche bzw. eine von dem Substrat weg gewandte Oberfläche eines oder mehrerer der Nanodrähte zumindest teilweise mit einer Nickel-Legierung versehen ist.

Mittels der Nickel-Legierung können elektrische Kontaktstellen auf den Nanodrähten ausgebildet werden. Gemäß der herrschenden Meinung auf dem einschlägigen technischen Gebiet wurde es auf Grund der erwarteten Oberflächenunregelmäßigkeiten lange Zeit für nicht als technisch umsetzbar angesehen, auf Strukturen im Nanometerbereich, wie z.B. Nanodrähten, mittels einer Nickel-Legierung Kontaktstellen auszubilden.

Erfindungsgemäß wird nun aber bewusst von dieser herrschenden Meinung abgewichen und es hat sich überraschen herausgestellt, dass sich auf den erfindungsgemäßen Nanodrähten mittels Nickel-Legierung funktionierende elektrische Kontaktstellen ausbilden lassen.

Zwischen dem Substrat und mindestens einem der Nanodrähte kann eine vorzugsweise durch epitaktisches Wachstum aufgebrachte Zwischenschicht angeordnet sein, welche teilweise oder vollständig aus Silizium-Carbid, vorzugsweise 4H-SiC, besteht. Die Zwischenschicht (auch als Epilayer bezeichnet) ist optional und kann weggelassen werden. Vorzugsweise ist die Zwischenschicht zwischen dem Substrat und allen Nanodrähten eines erfindungsgemäßen Bauteils angeordnet.

Das Substrat, die Zwischenschicht und oder die Nanodrähte können jeweils teilweise oder vollständig, beispielsweise ausschließlich, aus 4H-SiC bestehen.

Das Substrat und / oder die Zwischenschicht ist oberflächennah vorzugsweise mit N-Atomen dotiert, vorzugsweise mit einer Menge von 5 × 10¹³ cm⁻² bis 7 × 10¹³ cm⁻², insbesondere von ca. 6 × 10¹³ cm⁻² N-Atomen dotiert. Die Zwischenschicht kann höher dotiert sein als das Substrat, sodass ein Dotierungsgradient zwischen der Zwischenschicht und dem Substrat besteht.

Die oberflächennahe Dotierungstiefe beträgt vorzugsweise 100 bis 200 nm mit einem Maximum bei 20 nm bis 30 nm, insbesondere von ca. 25 nm. Wird danach ein Teil des Substrats und / oder der Zwischenschicht zu Ausbildung der Nanodrähte abgetragen, so besteht vorzugsweise ein Dotierungsgradient zwischen den Nanodrähten und der Zwischenschicht bzw. dem Substrat. Vorzugsweise sind die Nanodrähte höher dotiert als die Zwischenschicht bzw. das Substrat.

In anderen Worten besteht vorzugsweise ein Dotierungsgradient zwischen mindestens einem oder mehrerer oder aller der Nanodrähte und dem Substrat und / oder der Zwischenschicht, wobei vorzugswiese der Nanodraht oder die Nanodrähte einen höheren Dotierungsgrad aufweist / aufweisen als das Substrat und / oder die Zwischenschicht.

Vorzugsweise hat mindestens einer oder mehrere oder alle der Nanodrähte eines erfindungsgemäßen Bauteils eine Breite von ca. 15 nm bis 80 nm, insbesondere zwischen 30 nm und 70 nm und / oder eine Länge von 1 µm bis 15 µm, vorzugsweise zwischen 10 µm und 15 µm, und / oder eine Höhe von 25 nm bis 40 nm, insbesondere zwischen 30 nm und 35 nm. Ein erfindungsgemäßes Bauteil kann eine Mehrzahl an Nanodrähten aufweisen.

Um den Ladungstransfer eines erfindungsgemäßen Bauteils bzw. eines seiner Nanodrähte auf die elektrischen Anschlussstellen des Nanodrahts zu begrenzen, kann eine elektrische Anschlussstelle des Nanodrahts neben der Nickel-legierung zusätzlich Palladium aufweisen.

Vorzugsweise weist / weisen mindestens einer oder mehrere oder alle der Nanodrähte mindestens eine Palladium aufweisende elektrische Kontaktstelle auf, wobei vorzugsweise eine Nickel-Legierungsschicht zwischen dem jeweiligen Nanodraht und der zugehörigen Kontaktstelle(n) angeordnet ist. In anderen Worten befindet sich die Nickel-Legierungsschicht vorzugsweise zwischen einer dem Substrat abgewandten Oberfläche eines Nanodrahts bzw. ist in diese Oberfläche hineinlegiert und einer Palladiumbeschichtung.

Die Palladiumbeschichtung überlagert vorzugsweise die Nickellegierung zumindest teilweise.

Vorzugsweise sind die elektrischen Kontaktstellen kreisförmig und/oder lang gestreckt..

Weiterhin weist / weisen vorzugsweise mindestens einer oder mehrere oder alle der Nanodrähte eines erfindungsgemäßen Bauteils im Niederspannungsbereich, vorzugsweise zwischen 10 mV und 100 mV, eine lineare, ohmsche Widerstandscharakteristik auf. Es besteht somit vorzugsweise ein linearer Zusammenhang zwischen der angelegten Spannung und dem fließenden Strom im Niederspannungsbereich.

Diese Charakteristik der erfindungsgemäßen Nanodrähte war ausgehend vom Stand der Technik nicht zu erwarten, denn ein derartiges, lineares und ohmsches Verhalten im Niederspannungsbereich galt bei der Ausbildung von Nanodrähten als technisch nicht erreichbar.

Neben der Ladungsinjektion, welche sich in der Widerstandscharakteristik wiederspiegelt, ist der Ladungstransport selbst relevant. Basierend auf dem oberflächennahen kontinuierlichen Dotierungsprofil ist prinzipiell ein Strombeitrag in Bereichen des Substrats/der Epilayer unterhalb des Nanodrahtes vorstellbar. Jedoch ist dieser Beitrag durch die Eindringtiefe und auch mit Eindringtiefe abnehmenden Stärke des stromtreibenden, angelegten elektrischen Feldes limitiert.

Faktisch könnte eine klarere bzw. abrupte Implantationsgrenze durch eine entsprechende, tieferliegende Gegendotierung erreicht werden oder durch entsprechende Anpassungen im Implantationsprozess (der Dotieratome) durch z.B. Beschleunigungsspannung oder Schutzschichten auf der Substrat/Epilayer-Oberfläche (z.B. aus SiO₂ oder andere).

Der Strombeitrag aus den Bereichen des Substrats/der Epilayer unterhalb des Nanodrahtes lässt sich abschätzen: Typische Spannungen liegen im 10 mV Bereich. Typische Abstände zwischen Ladungsinjektion und -extraktion (stromführende Kontakte) liegen im 500 nm Bereich. Die Eindringtiefe und die Stärke des elektrischen Feldes lässt sich abschätzen durch eine elektrische Dipolapproximation [B.B. Laud (1987), "Electromagnetics", 2nd edition,New Age International, p. 25, ISBN 978-0-85226-499-7] oder durch eine Plattenkondensatorapproximation (S. Catalan-Izquierdo, J.-M. Bueno-Barrachina, C.-S.Canas-Penuelas, F. Cavalle-Sese. Capacitance evaluation on parallel-plate capacitors by means of finite element analysis. RE_PQJ 1, 613-616 (2009), https://doi.ora/10.24084/repqj07.451). Generell zeigt ein elektrisches Feld einen starken Abfall mit 1/Abstand³ (Abstand gemessen von Punkt des elektrischen Kontaktes). Ein starker Abfall spiegelt sich auch in beiden Approximationen wider. In diesen fällt die elektrische Feldstärke auf (i) etwa 1% im Abstand von ca. 25% des Abstandes der elektrischen Kontakte (in unserem Fall ca. 120 nm, da Kontaktabstand 500 nm). Ein Abfall auf (ii) 0.1% Feldstärke sind erreicht bei etwa 70% des Abstandes der elektrischen Kontakte. Diese abfallende Feldstärke ist ferner unter dem Gesichtspunkt zu betrachten, dass das Dotierprofil gleichzeitig mit der Tiefe abfällt und somit, der effektive Widerstand des Bereiches unterhalb des Nanodrahtes kontinuierlich zunimmt.

Zur Veranschaulichung: Ein Nanodraht mit Höhe 33 nm und Breite 46 nm zeigt in einer Zwei-Punkt Strom-Spannungsmessung etwa 7 kΩ Widerstand und bei 10 mV angelegtem Spannungsbereich einen Strom von einigen hundert nA bis zum µA Bereich. Unter der Annahme, dass ein gleichförmiges elektrisches Feld vorliegen würde unterhalb des Nanodrahtes (was nicht der Fall ist, folgendes ist also eien Überschätzung des Strombeitrags), so ergäbe sich ein Widerstand für (i) von ca. 100 kΩ und für (ii) von ca. 2 kΩ. Für eine angelegte Spannung von 10 mV an den Kontaktstellen erwartet man in beiden Fällen einen Beitrag von einigen nA, also kleiner als experimentell gemessen. Dies zeigt, dass ein signifikanter Teil des Stromes durch den Nanodraht fließt und somit die Nanodrähte als definierte Stromträger qualifiziert.

Ein weiterer Aspekt der vorliegenden Erfindung betrifft ein Verfahren zur Herstellung eines mikroelektronischen Bauteils mit mindestens einem Nanodraht, vorzugsweise eines mikroelektronischen Bauteils gemäß der vorliegenden Erfindung.

Ein erfindungsgemäßes Verfahren umfasst vorzugsweise die folgenden Schritte:
- Bereitstellung eines Siliziumcarbid, vorzugsweise 4H-SiC, enthaltenden Substrats,
- Oberflächennahes Dotieren des Substrats, vorzugsweise mit N-Atomen, vorzugsweise mit einer Menge von 5 × 10¹³ cm⁻² bis 7 × 10¹³ cm⁻², insbesondere von ca. 6 × 10¹³ cm⁻² N-Atomen, und vorzugsweise einer Dotierungstiefe von 100 bis 200 nm mit einem Maximum bei 20 nm bis 30 nm, insbesondere von ca. 25 nm,
- Aufbringen einer Schicht aus Calixaren auf das Substrat,
- Teilweises Abtragen der Schicht aus Calixaren, wobei nicht-abgetragenes Calixaren mittels Elektronenstrahl-Lithographie fixiert/exponiert und zur Ausbildung einer Ätzmaske genutzt wird, welche die Konturen einer Anzahl an Nanodrähten auf dem Substrat definiert,
- Entfernen von nicht dem Elektronenstrahl exponierten Calixaren-Resten mittels Xylenl,
- Wärmebehandeln des Substrats mit aufgebrachter Ätzmaske bei einer Temperatur zwischen 110°C und 150 °C, vorzugsweise zwischen 120°C und 140 °C, insbesondere bei ca. 130 °C für eine Zeit zwischen 10 Minuten und 40 Minuten, vorzugsweise zwischen 15 Minuten und 30 Minuten, insbesondere zwischen 20 Minuten und 25 Minuten.

Das Calixaren ist vorzugsweise 4-Methyl-1-acetoxycalix[6]aren. Im Gegensatz zu bekannten Verfahren, bei denen Calixaren zum Einsatz kommt, kann ein erfindungsgemäßes Verfahren mindestens einen der folgenden Schritte aufweisen:
Erhitzen der mit Calixaren beschichteten Substrate, beispielsweise auf einer Heizplatte bei 130 °C für 2 Minuten, wobei die Umgebung bei Raumtemperatur ist und die Umgebung normale Atmosphäre ist (kein Vakuum oder Formiergas notwendig). Außerdem kann nach der Elektronenstrahl-Belichtung und vor der Entwicklung ein Post-Bake-Schritt (beispielsweise auf einer Heizplatte, 145 °C, 1 Minute, bei Raumtemperatur, normale Umgebung) und / oder nach der Xylen-Entwicklung ein zusätzlicher Hardbake-Schritt (ca. 20 Minuten bei 130 °C, vorzugsweise bei Raumtemperatur und normaler Umgebung) zur Härtung der Ätzmaskenschicht vorgesehen sein.

Der Wärmebehandlungsschritt (auch als Annealing bezeichnet) des vorstehend beschriebenen erfindungsgemäßen Verfahrens ist aus dem Stand der Technik nicht bekannt und hat den technischen Effekt, dass Xylen-Rückstände verdampft werden und die Ätzmaske aushärtet.

Weiterhin kann eine erfindungsgemäßes Verfahren die folgenden Schritte umfassen:
- Abtragen eines nicht durch die Ätzmaske geschützten Bereichs des Substrats mittels reaktiven Ionenätzens (z.B. mittels CF₄ oder SF₆ oder anderen) bei einer Ätzrate von vorzugsweise 1,5 nm/s, sodass eine Anzahl an Nanodrähten auf dem Substrat entsteht, und
- Entfernen von Calixaren-Resten auf einer dem Substrat abgewandten Oberfläche der Nanodrähte mittels eines weiteren Ätzschritts, in welchem vorzugsweise eine gepufferte Lösung zum Einsatz kommt, die eine oder mehrere Komponenten ausgewählt aus der folgenden Liste aufweist: HF, H₂SO₄, NH₃, HCl und H₂O₂.

Auch der Schritt des Entfernens der Calixaren-reste ist aus dem Stand der Technik nicht bekannt. Durch diesen Schritt werden Oberflächenungenauigkeiten weiter reduziert. Unter einer dem Substrat abgewandten Oberfläche der Nanodrähte ist vorzugsweise eine Oberfläche eines jeweiligen Nanodrahts zu verstehen, die von dem Substrat weg gewandt ist.

Um elektrische Kontaktstellen auf den Nanodrähten auszubilden, können die nachstehenden Verfahrensschritte zum Einsatz kommen:
- Aufbringen einer elektronensensitiven Positivlackschicht (z.B. PMMA oder andere) und darauffolgende lokale Belichtung mittels Elektronenstrahl auf den zuvor geätzten/definierten Nanodraht. Die lokal belichteten Stellen werden mittels geeigneter Lösungsmittel (z.B. MIBK:IPA oder andere) entfernt.
- Aufbringen einer Nickelschicht auf mindestens einen ersten Teilbereich eines Nanodrahts, wobei der Nanodraht eine Breite von ca. 15 nm bis 80 nm, insbesondere zwischen 30 nm und 70nm und / oder eine Länge von 1 µm bis 15 µm, vorzugsweise zwischen 10 µm und 15 µm, und / oder eine Höhe von 25 nm bis 40 nm, insbesondere zwischen 30 nm und 35 nm, aufweist und die Nickelschicht eine Dicke von 10 nm bis 20 nm, vorzugsweise eine Dicke von ca. 15 nm, aufweist;
- Teilweises Abtragen der Nickelschicht (sogenannter Lift-off Prozess), sodass auf der dem Substrat abgewandten Oberfläche des Nanodrahts mindestens ein lokal begrenztes, Nickelvolumen zurückbleibt, dessen Durchmesser vorzugsweise im Bereich zwischen 20 bis 110 nm, vorzugsweise zwischen 30 nm und 100 nm liegt,
- Wärmebehandeln für ca. 1000°C für eine Zeit zwischen 2 Minuten und 10 Minuten, vorzugsweise für 5 Minuten, wodurch das Nickelvolumen eine lokal begrenzte Nickellegierung mit der Oberfläche des Nanodrahts ausbildet, welche eine elektrische Kontaktstelle ausbildet.

Herkömmlicherweise wurden bekannte Nickel-Legierungsschritte ausschließlich im Mikrometer bis Zentimeter-Bereich angewandt. Überraschend hat sich gemäß der vorliegenden Erfindung herausgestellt, dass eine Nickel-Legierung auch bei Nanodrähten von nur wenigen Nanometern Breite erfolgreich zur Ausbildung elektrischer Kontaktstellen einsetzbar ist.

Das lokal begrenzte Nickel-Legierungsvolumen hat vorzugsweise die Form einer Säule oder einer angenäherten Kugel.

Weiterhin kann ein erfindungsgemäßes Verfahren die folgenden Schritte aufweisen:
- Aufbringen einer elektronensensitiven Positiv- (z.B. PMMA oder andere) oder Negativlackschicht (z.B. nLOF oder andere) und darauffolgende lokale Belichtung mittels Elektronenstrahl auf den zuvor geätzten/definierten Nanodraht. Die lokal belichteten Stellen werden mittels geeigneter Lösungsmittel (z.B. MIBK:IPA oder andere bzw. TMAH:H₂O für Positiv- bzw. Negativlack) entfernt.
- Aufbringen einer Palladiumschicht auf mindestens einen zweiten Teilbereich des Nanodrahts, wobei der zweite Teilbereich den ersten Teilbereich mit der Nickellegierung zumindest teilweise überlagert und die Palladiumschicht eine Dicke von 30nm bis 50nm, vorzugsweise eine Dicke von ca. 40nm aufweist,
- Teilweises Abtragen der Palladiumschicht (sogenannter Lift-off Prozess), sodass auf der dem Substrat abgewandten Oberfläche des Nanodrahts mindestens ein lokal begrenztes, vorzugsweise langgestrecktes Palladiumvolumen zurückbleibt, welches das Nickelvolumen zumindest teilweise oder vollständig überlagert und somit eine Stromeinspeisung und einen Stromausfluss in und aus dem Nanodraht auf einen Bereich der elektrischen Kontaktstelle begrenzt, in welchem das Palladiumvolumen die Nickellegierung überlagert.

Mittels des Palladiums lässt sich der Ladungstransfer des behandelten Nanodrahts sehr gut auf die definierten elektrischen Kontaktstellen begrenzen, da Palladium eine starke Schottky-Barriere von ca. 1 eV zu dem 4H-SiC des Nanodrahts ausbildet. Die Stromeinspeisung und der Stromausfluss in und aus dem Nanodraht sind Beispiele eines Ladungstransfers.

Weiterhin betrifft die vorliegende Erfindung eine Verwendung eines Verfahrens gemäß der vorliegenden Erfindung zur Herstellung mindestens eines Nanodrahts, welcher im Niederspannungsbereich, vorzugsweise zwischen 10 mV und 100mV, eine lineare, ohmsche Widerstandscharakteristik aufweist und vorzugsweise teil eines mikroelektronischen Bauteils gemäß der vorliegenden Erfindung ist.

An dieser Stelle wird darauf hingewiesen, dass die Begriffe "ein" und "eine" nicht zwingend auf genau eines der Elemente verweisen, wenngleich dies eine mögliche Ausführung darstellt, sondern auch eine Mehrzahl der Elemente bezeichnen können. Ebenso schließt die Verwendung des Plurals auch das Vorhandensein des fraglichen Elementes in der Einzahl ein und umgekehrt umfasst der Singular auch mehrere der fraglichen Elemente.

Weiterhin können alle hierin beschriebenen Merkmale der Erfindung beliebig miteinander kombiniert oder voneinander isoliert beansprucht werden.

Weitere Einzelheiten und Vorteile der Erfindung werden nachstehend unter Bezugnahme auf die Figuren erläutert.

Hierbei zeigt:
Fig. 1 ein erfindungsgemäßes mikroelektronisches Bauteil in Perspektivansicht;
Fig. 2 ein erfindungsgemäßes mikroelektronisches Bauteil mit Zwischenschicht im Schnitt;
Fig. 3 ein Flussdiagramm eines erfindungsgemäßen Verfahrens zur Ausbildung von Nanodrähten; und
Fig. 4 ein Flussdiagramm eines erfindungsgemäßen Verfahrens zur Ausbildung elektrischer Kontaktstellen auf einem Nanodraht.
Fig. 5 eine Aufnahme mittels eines Scan-Elektronenmikroskops eines erfindungsgemäßen Bauteils mit einem Nanodraht (linkes Panel a)) und eine schematische Schnittansicht (rechtes Panel b)) des erfindungsgemäßen Bauteils aus Panel a).
Fig. 6 einen Graphen, welcher das lineare, ohmsche Verhalten zweier Nanodrähte in einer Zwei-Punkt Strom-Spannungs-Messung eines erfindungsgemäßen Bauteils illustriert.
Fig. 7 eine Aufnahme eines erfindungsgemäßen Bauteils mit einem besonders lang erstreckten Nanodraht.

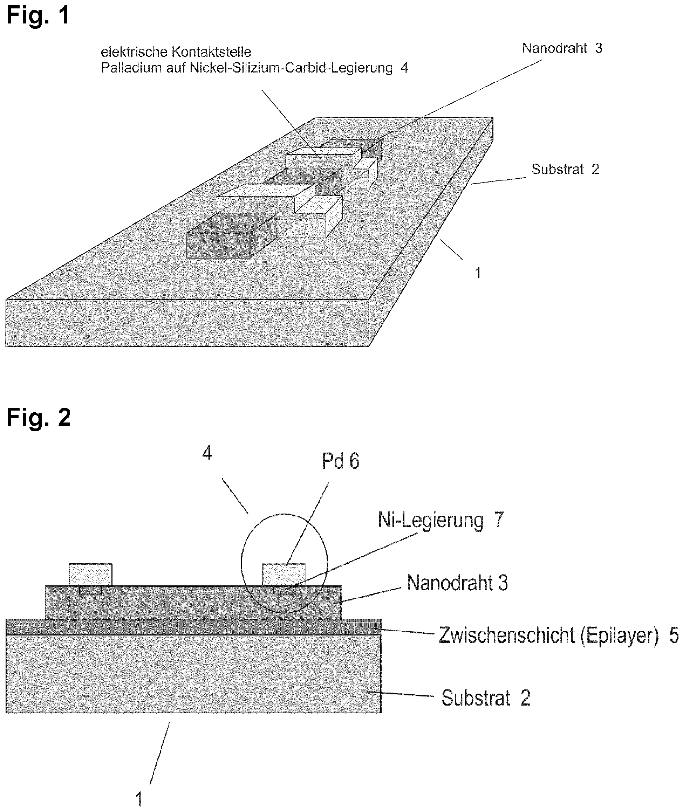

Wie in Fig. 1 gezeigt, weist ein erfindungsgemäßes mikroelektronisches Bauteil 1 ein Substrat 2 auf, auf welchem exemplarisch ein Nanodraht 3 gezeigt ist. Selbstverständlich kann eine beliebige Anzahl an Nanodrähten vorhanden sind.

Der Nanodraht 3 weist zwei elektrische Kontaktstellen 4 auf, deren Längsachse sich rechtwinklig zu der Längsachse des Nanodrahts 3 erstreckt. Die Kontaktstellen 4 werden durch Bereich gebildet, in welchen eine Palladium-Beschichtung eine Nickel-4H-SiC-Legierung überlagert.

Wie in Fig. 2 gezeigt, weist ein anderes erfindungsgemäßes mikroelektronisches Bauteil 1 ein Substrat 2 auf, auf welchem exemplarisch ein Nanodraht 3 gezeigt ist.

Zwischen dem Nanodraht 3 und dem Substrat 2 ist eine Zwischenschicht / Epilayer 5 aus 4H-SiC angeordnet.

In dieser Darstellung ist zudem erkennbar, dass die Kontaktstellen 4 jeweils durch Bereiche gebildet werden, in welchen eine Palladium-Beschichtung 6 eine Nickel-4H-SiC-Legierung 7 überlagert.

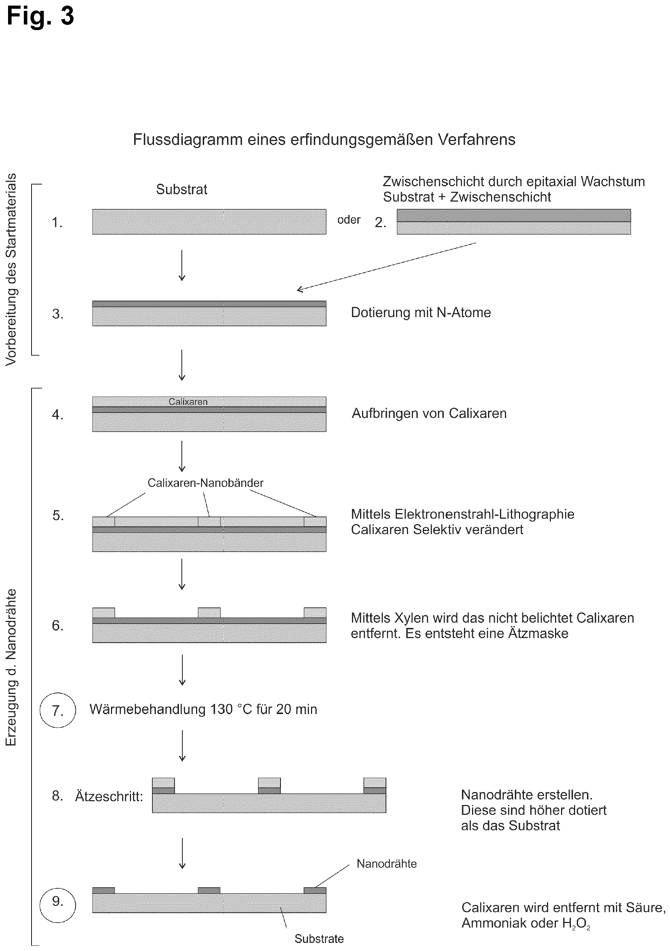

Fig. 3 zeigt ein Flussdiagramm eines erfindungsgemäßen Verfahrens zur Ausbildung von Nanodrähten. Vorbereitung des Ausgangsmaterials:
(1) Als Substrat wurde ein n-dotierter 4H-SiC-Wafer verwendet, der aus einem n-Typ-Substrat mit einem spezifischen Widerstand von etwa 15 mΩ cm (entsprechend einer Stickstoff-Dotierstoffkonzentration von 10¹⁸ cm⁻³) besteht bzw. dieses aufweist. Dotierung erfolgt durch Substitution von C durch N.
(2) Auf dem Substrat wird eine epitaktisch gewachsene 4H-SiC-Schicht definiert. Diese Zwischenschicht oder Epilayer ist z.B. 4,7 µm hoch und hat eine nominale Dotierungskonzentration von N-Atomen von 10¹⁶ cm⁻³. Das beschriebene Verfahren funktioniert auch mit einem sogenannten halbisolierenden 4H-SiC-Wafer (HPSI) allein, also ohne Epilayer.
(3) Um die Epilayer mit N-Atomen (Dotierstoffen) anzureichern, wird die Epilayer zunächst mit einer vorzugsweise 30 nm dünnen SiO₂-Schicht überzogen (z. B. durch Sputterdeposition oder ähnliches). Dann wird das Substrat mit der Epilayer und dem SiO₂ in einen lonenimplantator gegeben. Stickstoffionen mit einer Beschleunigungsspannung von 25 keV und einer Durchflussrate von 6×10¹³ cm⁻² werden dann oberflächennah in die Epilayer implantiert.
   Nach der Implantation wird die SiO₂-Schicht mit HF entfernt. Anschließend wird eine Kohlenstoff-Deckschicht (z.B. nLOF-Fotoresist) auf das implantierte Substrat aufgebracht (Dicke ca. 4 µm, z.B. durch Spin-Coating). Das gesamte Bauteil wird dann bei 1700°C für 30 min in Ar-Atmosphäre (ca. 900 mbar) getempert. Die Kohlenstoff-Deckschicht wirkt als Oxidationsinhibitor. Die Kohlenstoff-Deckschicht wird dann durch reaktives nasschemisches Ätzen in einem mehrstufigen Verfahren mit gepufferten Lösungen von HF, H₂SO₄, NH₃, HCl und H₂O₂ entfernt.
(4) 4-Methyl-1-acetoxycalix[6]aren verdünnt in Chlorbenzol (Konzentration 1,5 Gew.-%) wird auf die Epilayer aufgebracht. Beispielsweise wird die Lösung auf die Oberfläche geschleudert (3000 U/min, 50 s) und als negativer elektronenstrahlempfindlicher Resist (120 nm Dicke) verwendet, der als Ätzmaske dient.
(5) Mit Hilfe der Elektronenstrahllithografie werden Calixaren-Nanobänder auf der Epilayer-Oberfläche definiert. Die Belichtungsdosis wird vorzugsweise variiert, um Linien mit unterschiedlicher Breite zu erhalten.
(6) Der nicht belichtete Resist wurde mit Xylen (auch als Xylol, englisch Xylene, bezeichnet) entfernt.
(7) Die Bauteile werden daraufhin 20 Minuten lang bei 130°C wärmebehandelt unter normaler Atmosphäre und Raumtemperatur.
(8) Anschließend wurde ein reaktives Ionenätzverfahren (z.B. CF₄:O₂:N₂) angewandt, um den Bereich zu ätzen, der nicht vom Calixaren bedeckt ist (Ätzrate von SiC 1,5 nm/sec). Als Ergebnis verbleiben von oben nach unten (top down) definierte Nanodrähte auf der Oberfläche. Durch Variation der Ätztiefe kann die Höhe der Nanodrähte so eingestellt werden, dass sie in den Tiefenbereich des Dotierungsprofils fällt. Es wird vorzugsweise ein Dotierungsgradient zwischen Nanodraht und darunterliegender Epilayer erreicht (der Nanodraht hat mehr Dotierungsstoffe als die Epilayer, auf der er sitzt).
(9) Calixaren-Reste auf den Nano-Drähten werden durch reaktives chemisches Ätzen mit gepufferten Lösungen von HF, H₂SO₄, NH₃, HCl und / oder H₂O₂ entfernt. Im Stand der Technik wurde noch nicht offenbart, Calixaren nach der Lithografie zu entfernen und anschließend zu ätzen.

Als Ergebnis von Schritt 9 liegt ein mikroelektronisches Bauteil mit einem Substrat, einer Zwischenschicht und einer Anzahl an darauf angeordneten Nanodrähten vor, auf denen elektrische Kontaktstellen ausbildbar sind.

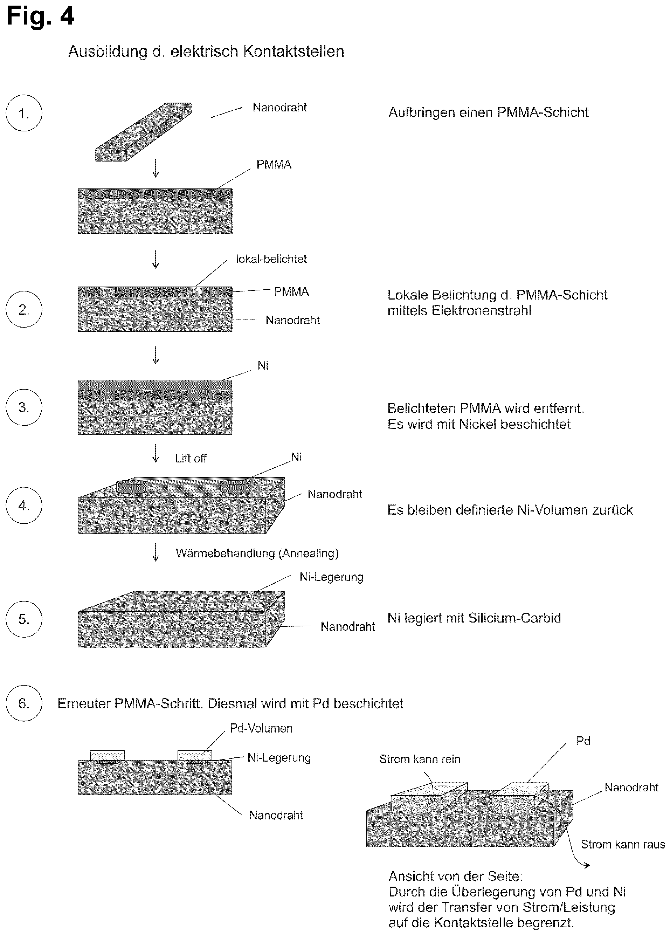

Fig. 4 zeigt ein Flussdiagramm eines erfindungsgemäßen Verfahrens zur Ausbildung elektrischer Kontaktstellen auf einem Nanodraht.

Ausbildung von elektrischen Kontakten und elektrische Charakterisierung:
(1) Zunächst wird auf einen Nanodraht eine einlagige, elektronenempfindliche PMMA-Positivresistschicht aufgebracht, die 50 s lang mit einer Drehzahl von 3000 U/min aufgeschleudert wurde. Die Dicke der PMMA-Schicht beträgt vorzugsweise 140 nm. Das PMMA wurde für die Spin-Coating-Beschichtung in Anisol in einer Konzentration von 3 Gew.-% aufgelöst.
(2) Die PMMA-Schicht auf dem Nanodraht wird lokal mit dem Elektronenstrahl belichtet (typische Dosis 140 µC/cm²). Der belichtete Bereich wird nasschemisch mit MIBK:IPA (Verhältnis 1:3) entfernt, gefolgt von einer IPA-Spülung.
(3) Nach dem Entfernen des belichteten PMMA wird Ni in einer Dicke von 15 nm aufgesputtert oder durch andere Materialabscheidungsverfahren aufgebracht.
(4) Das unerwünschte Ni wird durch ein nasschemisches Verfahren (Lösungsmittel: Aceton, Dauer: 5 Minuten) abgehoben ("Lift-off"), so dass 15 nm große Ni-Punkte/Säulen auf dem Nanodraht zurückbleiben, deren Umfangsfläche einen Durchmesser von 30 bis 100 nm hat (immer kleiner als die Breite des Nanodrahts).
(5) Zur Herstellung des ohmschen elektrischen Kontakts werden die Bauteile zunächst 5 Minuten lang bei 1000 °C durch schnelles thermisches Ausglühen wärmebehandelt. Dies fördert die Silizidierung des Ni in den Nanodrähten und die Ausbildung einer Nickel-Silizium-Carbid-Legierung. Ein derartiger Silizidierungsprozess wird herkömmlich nur in größerem Maßstab durchgeführt (Zehntausende von µm² bis cm²).
(6) In einem zweiten PMMA-basierten Elektronenstrahllithografieschritt (wie vorstehend beschrieben) werden langgestreckte, fingerartige Strukturen auf der Oberseite der Nanodraht-Ni-Legierungsbereiche definiert. Diese Fingerstrukturen werden dann vorzugsweise so erweitert, dass sie größere elektrische Kontaktelektroden/Pads bilden können. Die Höhe des PMMA beträgt vorzugsweise 140 nm und wird z.B. durch Schleuderbeschichtung bei 3000 U/min für 50 Sekunden erreicht. Das PMMA wurde für das Spincoating in Anisol mit einer Konzentration von 3 Gew.-% gelöst.

Palladium (Dicke 40 nm) wird durch Elektronenstrahlverdampfung des Materials aufgebracht. Palladium wurde gezielt ausgewählt, da es eine große Schottky-Barriere (~ 1 eV) zu 4H-SiC erzeugt.

Daraufhin wird ein Lift-off-Schritt (wie vorstehend beschrieben) durchgeführt, bei welchem Palladiumstrukturen auf den 4H-SiC-Nanodrähten zurückbleiben. Die Ladungsinjektion und -extraktion erfolgt somit vorteilhaft nur über die Stellen, an denen sich Ni-Silicid (Nickel-Legierung) unter den Pd-Strukturen befindet.

Mit dem beschriebenen Verfahren lassen sich Nanodrähte ausbilden, die im Niederspannungsbereich (< 100 mV) ohmsche Kontakte ausbilden. Die Ausbildung von Nanodrähten aus 4H-SiC, die im Niederspannungsbereich (< 100 mV) ohmsche Kontakte darstellen, ist aus dem Stand der Technik nicht bekannt.

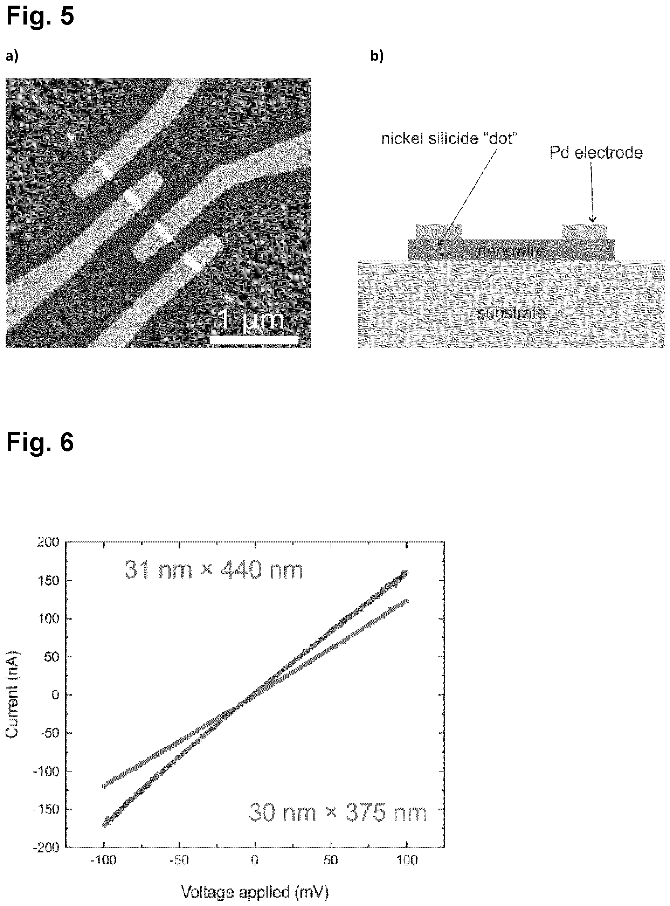

Fig. 5 illustriert einen erfindungsgemäßen Nanodraht mit zwei Pd-Elektroden, welche sich jeweils über einem Bereich einer Nickel-Silizium-Legierung befinden.

Kontakte auf Nickelbasis zu n-Typ 4H-SiC können wegen ihres geringen spezifischen Kontaktwiderstands verwendet werden, um ohmsche Kontakte zu bilden. Je nach Glühtemperatur liegen die spezifischen Kontaktwiderstände von Ni und Ni-basierten Kontakten, die typischerweise im Temperaturbereich von 900 °C bis 1100 °C geglüht werden, in der Größenordnung von 10⁻⁶ bis 10⁻³ Ωcm².

Während des Glühens entstehen die ohmschen Kontakte beispielsweise durch sehr effiziente Reaktionen von Ni mit SiC zur Bildung von Siliziden, von denen vorzugsweise Ni₂Si die Schlüsselphase ist, die die Elektronentransporteigenschaften im Bereich der Kontakt-Grenzfläche bestimmt. Obwohl zahlreiche Studien zur Bildung von Nickel-Silizid-Kontakten zu 4H-SiC vom n-Typ durchgeführt wurden, waren die Kontakte im Allgemeinen makroskopisch, mit lateralen Abmessungen von typischerweise einigen hundert µm und mit einer Nickeldicke in der Größenordnung von 100 nm.

Gemäß der vorliegenden Anmeldung wurden die seitlichen Abmessungen der Nickelkontakte erheblich reduziert, da die auf der Oberfläche der Nanodrähte abgeschiedenen Ni-Punkte kleiner waren als die Gesamtabmessungen des Drahtes. Außerdem wurde eine dünne Metallisierungsschicht von max. 15 nm Höhe eingesetzt.

Wenn man bedenkt, dass die Silizidphase unter der SiC-Oberfläche in eine Tiefe reicht, die geringfügig kleiner ist als die ursprüngliche Höhe des abgeschiedenen Metalls, würde dies auch für einen sehr kleinen Nanodraht zu einer effektiven Kontaktfläche für die Strominjektion über die Silizid/Nanodraht-Grenze in der Größenordnung von 3×10⁴ nm² führen.

Im Vergleich zu einer typischen, bekannten Oberfläche in der Größenordnung von 8×10⁹ nm² im Falle kreisförmiger Kontakte mit einem Durchmesser von 100 µm und einer Dicke von 100 nm ist dies ein Unterschied in Größenordnungen. Dennoch wird erfindungsgemäß eine effiziente Strominjektion erreicht, wie die linearen Zweipunkt-Strom-Spannungs-Kennlinien bei niedriger Vorspannung (beispielhaft in Fig. 6 dargestellt) mit Zweipunkt-Widerständen in der Größenordnung von einigen hundert kΩ zeigen.

Unter Berücksichtigung der Kontaktgeometrien (z.B. Abmessungen des Punktes und Dicke der Silizidphase ca. 15 nm) hat sich in der Praxis herausgestellt, dass bei einigen erfindungsgemäßen Nanodrähten die Werte des spezifischen Kontaktwiderstands in demselben Bereich liegen, der auch für die in der Literatur untersuchten makroskopischen ohmschen Silizidstrukturen angegeben wird (10⁻⁶ bis 10⁻³ Ωcm²). Dies deutet darauf hin, dass der Silizidierungsprozess auch bei der Bildung eines nanoskaligen Silizidkontakts zu 4H-SiC effizient ist. Bemerkenswerterweise sind bei den beiden kleinsten im Rahmend er vorliegenden Erfindung untersuchten Drähten die Zweipunktwiderstände relativ gering (wenige bis einige zehn kΩ), was spezifischen Kontaktwiderständen von 4,9×10⁻⁶ Ωcm² bis hinunter zu 1,5×10⁻⁷ Ωcm² entspricht. Der extrem niedrige spezifische Kontaktwiderstand im letztgenannten Fall entspricht einem Punkt mit Abmessungen von 38 nm × 46 nm (15 nm Höhe).

Zumindest in einigen Fällen ist der spezifische Kontaktwiderstand von nanoskopischen Kontakten somit noch kleiner als der von makroskopischen Kontakten. Es kann vermutet werden, dass der Silizidierungsprozess durch die erhöhte Reaktivität von Nickel mit Silizium aufgrund der Senkung der Schmelztemperatur (charakteristisch für nanoskopische Metalle, genannt Schmelzpunktdepression) gefördert wurde. Andererseits wurde experimentell nachgewiesen, dass die elektrischen Eigenschaften von Metall-Silizium-Kontaktschnittstellen stark mit ihrer Dicke zusammenhängen, was sich in einer deutlichen Verringerung der effektiven Richardson-Konstante und der Barrierenhöhe mit der Verringerung der Höhe des Metallfilms bei Ni-Kontakten zu Si zeigt. Die Verringerung dieser Parameter ist höchstwahrscheinlich auf die Änderungen in der Legierungszusammensetzung der Silizidphase zurückzuführen. Ein ähnlicher Mechanismus ist auch bei den erfindungsgemäßen SiC-Nanodraht-Bauelementen zu erwarten. An dieser Stelle ist darauf hinzuweisen, dass alle in der vorliegenden Anmeldung aufgeführten Messungen bei Raumtemperatur durchgeführt wurden.

Fig. 6 zeigt das ohmsche Verhalten zweier Nanodrähte in einer Zwei-Punkt Strom-Spannungs-Messung, von denen einer eine Abmessung von 31 nm Höhe × 440 nm Breite und der andere eine Abmessung von 30 nm Höhe und 375 nm Breite hat.

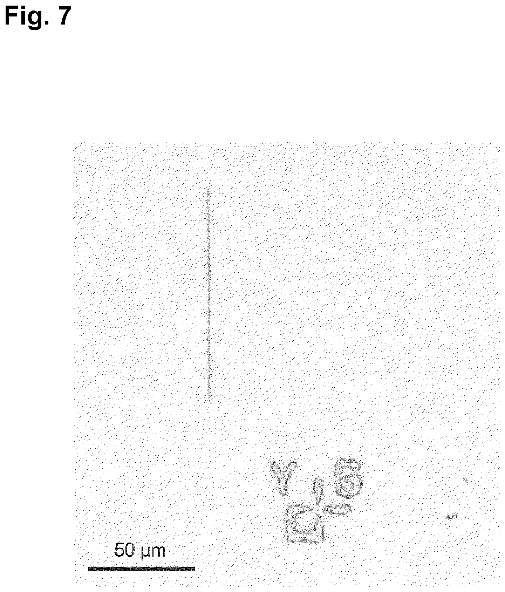

Fig. 7 der in Fig. 7 gezeigte Nanodraht hat eine Abmessung von 100 µm Länge, ca. 75 nm Breite und ca. 35 nm Höhe.

## Patentansprüche

1. Mikroelektronisches Bauteil, mit:
- einem zumindest teilweise aus vorzugsweise dotiertem Silizium-Carbid, vorzugsweise 4H-SiC, bestehenden Substrat,
- einer Anzahl an auf dem Substrat angeordneten, zumindest teilweise aus Silizium-Carbid, vorzugsweise 4H-SiC, bestehenden Nanodrähten, wobei
- eine dem Substrat abgewandte Oberfläche eines oder mehrerer der Nanodrähte zumindest teilweise mit einer Nickel-Legierung versehen ist.

2. Mikroelektronisches Bauteil gemäß Anspruch 1, wobei zwischen dem Substrat und mindestens einem der Nanodrähte eine vorzugsweise durch epitaxisches Wachstum aufgebrachte Zwischenschicht angeordnet ist, welche teilweise oder vollständig aus Silizium-Carbid besteht.

3. Mikroelektronisches Bauteil gemäß Anspruch 1 oder 2, wobei das Substrat und / oder die Zwischenschicht mit N- Atomen dotiert ist, vorzugsweise mit einer Menge von 5 × 10¹³ cm ⁻² bis 7 × 10¹³ cm ⁻², insbesondere von ca. 6 × 10¹³ cm ⁻² N-Atomen dotiert ist.

4. Mikroelektronisches Bauteil gemäß einem der vorhergehenden Ansprüche, wobei mindestens einer oder mehrere oder alle der Nanodrähte eine Breite von ca. 15 nm bis 80 nm, insbesondere zwischen 30 nm und 70n nm und / oder eine Länge von 1 µm bis 15 µm, vorzugsweise zwischen 10 µm und 15 µm, und / oder eine Höhe von 25 nm bis 40 nm, insbesondere zwischen 30 nm und 35 nm, haben.

5. Mikroelektronisches Bauteil gemäß einem der vorhergehenden Ansprüche, wobei mindestens einer oder mehrere oder alle der Nanodrähte mindestens eine Palladium aufweisende elektrische Kontaktstelle aufweist /aufweisen, wobei vorzugsweise eine Nickel-Legierungsschicht zwischen dem jeweiligen Nanodraht und der zugehörigen Kontaktstelle(n) angeordnet ist.

6. Mikroelektronisches Bauteil gemäß Anspruch 5, wobei sich eine Längsachse einer Kontaktstelle eines Nanodrahts rechtwinklig oder im Wesentlichen rechtwinklig zu einer Längsasche des die Kontaktstelle aufweisenden Nanodrahts erstreckt.

7. Mikroelektronisches Bauteil gemäß einem der vorhergehenden Ansprüche, wobei mindestens einer oder mehrere oder alle der Nanodrähte im Niederspannungsbereich, vorzugsweise zwischen 10 mV und 100mV, eine lineare, ohmsche Widerstandscharakteristik aufweisen.

8. Mikroelektronisches Bauteil gemäß einem der vorhergehenden Ansprüche, wobei ein Dotierungsgradient zwischen mindestens einem oder mehrerer oder aller der Nanodrähte und dem Substrat und / oder der Zwischenschicht besteht, wobei vorzugswiese der Nanodraht oder die Nanodrähte einen höheren Dotierungsgrad aufweist / aufweisen als das Substrat und / oder die Zwischensicht.

9. Anspruch auf die Leitfähigkeit der Nanodrähte (wartet auf Daten).

10. Verfahren zur Herstellung eines mikroelektronischen Bauteils mit mindestens einem Nanodraht, vorzugsweise eines mikroelektronischen Bauteils gemäß eines der vorhergehenden Ansprüche, mit den Schritten:
- Bereitstellung eines Siliziumcarbid enthaltenden Substrats,
- Dotieren des Substrats, vorzugswiese mit N- Atomen, vorzugsweise mit einer Menge von 5 × 10¹³ cm ⁻² bis 7 × 10¹³ cm ⁻², insbesondere von ca. 6 × 10¹³ cm ⁻² N-Atomen, und vorzugsweise einer Dotierungstiefe von 20 nm bis 30 nm, insbesondere von ca. 25 nm,
- Aufbringen einer Schicht aus Calixaren auf das Substrat,
- Teilweises Abtragen der Schicht aus Calixaren mittels Elektronenstrahl-Lithographie zur Ausbildung eines Ätzmaske, welche die Konturen einer Anzahl an Nanodrähten auf dem Substrat definiert,
- Entfernen von nicht dem Elektronenstrahl exponierten Calixaren-Resten mittels Xylen,
- Wärmebehandeln des Substrats mit aufgebrachter Ätzmaske bei einer Temperatur zwischen 110°C und 150 °C, vorzugsweise zwischen 120°C und 140 °C, insbesondere bei ca. 130 °C für eine Zeit zwischen 10 Minuten und 40 Minuten, vorzugsweise zwischen 15 Minuten und 30 Minuten, insbesondere zwischen 20 Minuten und 25 Minuten.

11. Verfahren gemäß Anspruch 10, weiterhin mit den Schritten:
- Abtragen eines nicht durch die Ätzmaske geschützten Bereichs des Substrats mittels einer Ätzlösung bei einer Ätzrate von vorzugsweise 1,5 nm/s, sodass eine Anzahl an Nanodrähten auf dem Substrat entsteht, und
- Entfernen von Calixaren-Resten auf einer dem Substrat abgewandten Oberfläche der Nanodrähte mittels eines weiteren Ätzschritts, in welchem vorzugsweise eine gepufferte Lösung zum Einsatz kommt, die eine oder mehrere Komponenten ausgewählt aus der folgenden Liste aufweist: HF, H₂SO₄, NH₃, HCl und H₂O₂.

12. Verfahren gemäß Anspruch 10 oder 11, weiterhin mit den Schritten:
- Aufbringen einer Nickelschicht auf mindestens einen ersten Teilbereich eines Nanodrahts, wobei der Nanodraht eine Breite von ca. 15 nm bis 80 nm, insbesondere zwischen 30 nm und 70n nm und / oder eine Länge von 1 µm bis 15 µm, vorzugsweise zwischen 10 µm und 15 µm, und / oder eine Höhe von 25 nm bis 40 nm, insbesondere zwischen 30 nm und 35 nm, aufweist und die Nickelschicht eine Dicke von 10nm bis 20 nm, vorzugsweise eine Dicke von ca. 15 nm, aufweist;
- Teilweises Abtragen der Nickelschicht, sodass auf der dem Substrat abgewandten Oberfläche des Nanodrahts mindestens ein lokal begrenztes, Nickelvolumen zurückbleibt, dessen Durchmesser vorzugsweise im Bereich zwischen 20 bis 110 nm, vorzugsweise zwischen 30 nm und 100 nm liegt,
- Wärmebehandeln für ca. 1000°C für eine Zeit zwischen 2 Minuten und 10 Minuten, vorzugsweise für 5 Minuten, wodurch das Nickelvolumen eine lokal begrenzte Nickellegierung mit der Oberfläche des Nanodrahts ausbildet, welche eine elektrische Kontaktstelle ausbildet.

13. Verfahren gemäß Anspruch 12, weiterhin mit den Schritten:
- Aufbringen einer Palladiumschicht auf mindestens einen zweiten Teilbereich des Nanodrahts, wobei der zweite Teilbereich den ersten Teilbereich mit der Nickellegierung zumindest teilweise überlagert und die Palladiumschicht eine Dicke von 30nm bis 50nm, vorzugsweise eine Dicke von ca. 40nm aufweist,
- Teilweises Abtragen der Palladiumschicht, sodass auf der dem Substrat abgewandten Oberfläche des Nanodrahts mindestens ein lokal begrenztes, vorzugsweise langgestrecktes Palladiumvolumen zurückbleibt, welches das Nickelvolumen zumindest teilweise oder vollständig überlagert und somit eine Stromeinspeisung und eine Stromausfluss in und aus dem Nanodraht auf einen Bereich der elektrischen Kontaktstelle begrenzt, in welchem das Palladiumvolumen die Nickellegierung überlagert.

14. Verwendung eines Verfahrens gemäß einem der Ansprüche 10 bis 14 zur Herstellung mindestens eines Nanodrahts, welcher im Niederspannungsbereich, vorzugsweise zwischen 10 mV und 100mV, eine lineare, ohmsche Widerstandscharakteristik aufweist und vorzugsweise teil eines mikroelektronischen Bauteils gemäß eines der Ansprüche 1 bis 9 ist.
